# DEMANDE DE BREVET EUROPEEN

(11) **EP 1 384 845 A1**
(43) Date de publication de la demande: **28.01.2004**
(21) Numéro de dépôt: 03102233.8
(22) Date de dépôt: 21.07.2003
(51) Int. Cl.: E05B 65/20, H03K 17/955

(54) **Capteur de présence pour poignée d'ouvrant, notamment pour véhicule automobile**

(30) Priorité: 23.07.2002 FR 0209463
(71) Demandeur: Valeo Sécurité Habitacle, 94042 Créteil Cedex (FR)
(72) Inventeur: MUSAT, Ciprian Valéo Sécurité Habitacle, 94000 Créteil (FR); HUTH, Jean-Claude Valéo Sécurité Habitacle, 92160 Antony (FR)
(74) Mandataire: Hervouet, Sylvie

(57) **Abrégé**

L'invention est relative à un capteur de présence destiné à être intégré dans une poignée d'ouvrant, notamment pour véhicule automobile, comportant un boîtier (1) en matériau non conducteur électriquement, de forme générale sensiblement parallélépipédique présentant une face avant (10) active et une face arrière (11) sensiblement parallèles, le boîtier étant destiné à être monté dans une partie mobile de la poignée d'ouvrant de façon à ce que ladite face avant (10) s'étende parallèlement à la surface de l'ouvrant et à distance de la surface de l'ouvrant; au moins une électrode de mesure (2) et une électrode de référence (3) reliée à une masse, placées à l'intérieur du boîtier et couplées entre elles de manière à générer des lignes de champs électriques s'étendant partiellement à l'extérieur du boîtier (1) de manière à créer une zone de détection au voisinage de la face avant (10) et de la face arrière (11); et un élément de blindage métallique (4) relié à la masse, placé à l'arrière de ladite face arrière et s'étendant en regard au moins de l'électrode de mesure (2), cet élément de blindage (4) présentant une structure ajourée choisie de manière à réduire les lignes de champs électriques de la zone de détection au niveau de la face arrière (11), tout en présentant une capacité parasite faible pour avoir une influence négligeable sur les lignes de champs électriques de la zone de détection au niveau de la face avant (10).

## Description

La présente invention est relative à un capteur de présence destiné à être intégré dans une poignée d'un ouvrant, notamment de véhicule automobile.

Elle concerne plus particulièrement un capteur de type capacitif comprenant au moins une électrode de mesure couplée à une électrode de référence de manière à pouvoir détecter l'approche d'une main d'utilisateur au voisinage de la poignée.

De tels capteurs peuvent par exemple être associés à des systèmes d'accès au véhicule automobile dits mains-libres, la détection de l'approche de la main initiant une communication radiofréquence entre un dispositif de reconnaissance situé sur le véhicule et un identifiant portatif porté par l'utilisateur de manière à ne permettre un déverrouillage de l'ouvrant qu'en cas d'authentification d'un identifiant autorisé.

On s'intéresse plus particulièrement dans la suite à un capteur capacitif dont les deux électrodes (de référence et de mesure) sont intégrées dans un même module, ce module étant destiné à être inséré dans la partie mobile d'une poignée d'ouvrant, à savoir la partie de la poignée que l'utilisateur va manoeuvrer pour ouvrir l'ouvrant.

Un capteur capacitif de cette nature est décrit par exemple dans le document DE 100 51 055 A1.

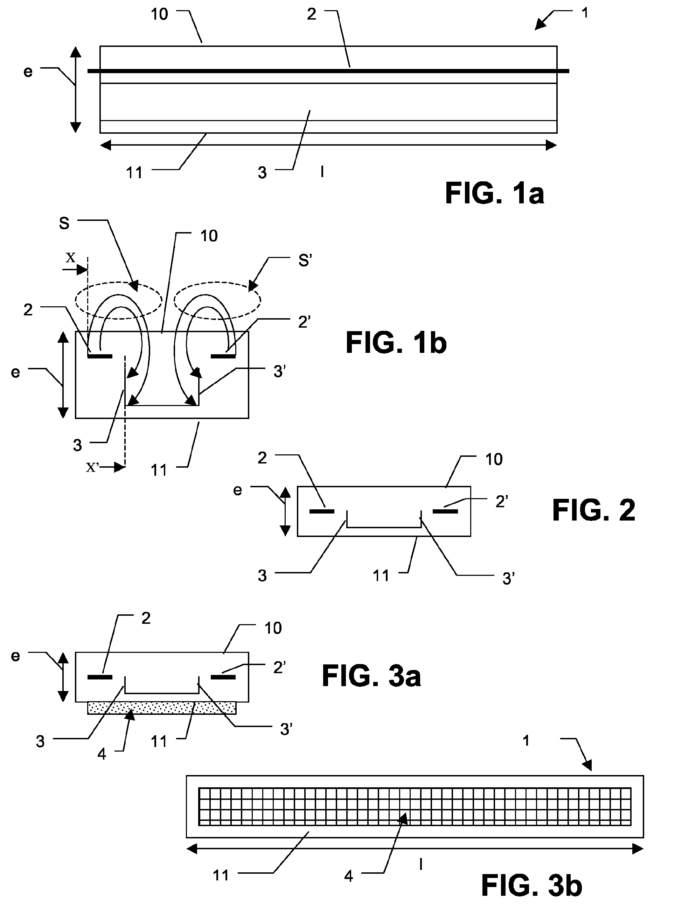

Un tel module est représenté schématiquement sur les figures 1a et 1b, la figure 1a étant une coupe selon le plan X-X' de la figure 1b. Le module se présente dans l'exemple sous la forme d'un boîtier 1 en matériau non conducteur électriquement, par exemple en plastique, de forme sensiblement parallélépipédique, avec une épaisseur e et une longueur l. Ce module est destiné à être monté, dans le sens de sa longueur, à l'intérieur de la partie mobile de la poignée d'ouvrant. Ainsi, l'axe longitudinal du module se trouvera, en position montée, sensiblement parallèle au plan de l'ouvrant portant la poignée. Pour faciliter la compréhension, la face supérieure (relativement aux figures 1a et 1b) du module 1 sera appelée dans la suite face avant du module, alors que la face opposée 11 sera appelée face arrière.

Lorsque le module 1 est monté au niveau de la partie mobile de la poignée, sa face dite avant 10 s'étend en regard du et parallèlement au panneau de l'ouvrant, et doit constituer la face active du capteur, en ce sens que l'on cherche à avoir une zone de détection d'approche de la main d'un utilisateur qui soit située entre cette face avant 10 et le panneau de l'ouvrant. De cette manière, la détection de l'approche est effectuée lorsque l'utilisateur s'apprête à saisir la poignée. La zone de détection idéale est représentée schématiquement en S sur la figure 1b. Cette zone de détection est créée grâce au couplage d'une électrode de mesure 2, reliée à une source de courant alternatif non représentée, et d'une électrode de référence 3 reliée à la masse du véhicule. Pour créer une zone de détection sur une longueur de la poignée correspondant à la longueur l du module, les électrodes de mesure 2 et de référence 3 s'étendent longitudinalement sur toute cette longueur. De préférence, l'électrode de mesure 2 s'étend, comme le montrent les figures, selon un plan parallèle à la face avant 10 du boîtier, et perpendiculaire au plan contenant l'électrode de référence 3. L'électrode de mesure 2 forme, avec l'électrode de référence 3, un condensateur dont la capacité va varier dès lors qu'une main pénètre dans la zone de détection S.

Par ailleurs, comme l'on souhaite en général que la main de l'utilisateur puisse être détectée que la poignée soit saisie par le dessus ou par le dessous, et si la géométrie de la poignée le permet, on prévoit de créer une seconde zone de détection notée S', symétrique à la zone de détection S par rapport à un plan perpendiculaire à la face active 10 et passant par le milieu de cette face active. Pour ce faire, on utilise une seconde électrode de mesure 2' couplée à une seconde électrode de référence 3' comme représenté sur la figure 1b. Dans ce cas, les électrodes de référence 3 et 3' peuvent être réalisées à partir d'une même plaque conductrice repliée de manière à présenter un profil en forme de U, comme visible sur la figure 1b. On peut alors avantageusement utiliser l'espace entre les deux électrodes de référence 3 et 3' pour y loger une antenne basse fréquence (non représentée).

Comme cela a été dit précédemment, les zones de détection S et S' représentent les zones de détection que l'on souhaiterait obtenir de façon idéale. Or, dans la pratique, les lignes de champs électriques reliant chaque électrode de mesure 2, 2' à son électrode de référence la plus proche 3, 3', ne sont pas uniquement celles représentées par les flèches sur la figure 1b. En particulier, certaines lignes de champ (non représentées) vont générer des zones de détection non voulues au niveau de la face arrière 11 du module. Il en résulte que le capteur pourra conclure à l'approche d'une main en vue d'une ouverture par simple effleurement de la surface extérieure de la poignée, sans qu'il y ait nécessairement une réelle volonté d'ouvrir l'ouvrant.

On conçoit donc que les contraintes liées à l'utilisation sur une poignée d'ouvrant obligent à créer une dissymétrie entre d'une part, les lignes de champs électriques générées sur la face avant 10 du module 1, et d'autre part, les lignes de champs électriques générées sur la face arrière 11 du module 1.

Une dissymétrie à peu près satisfaisante peut être obtenue lorsque l'épaisseur e du module est suffisamment importante, typiquement supérieure à 5 mm. En effet, dans ce cas, les électrodes de mesure 2 et 2' peuvent être placées, comme le montre la figure 1b, au plus près de la face avant 10, et par conséquent, le plus loin possible de la face arrière 11. Les lignes de champs électriques générées du côté de la face arrière 11 sont alors d'un niveau plus faible.

Cependant, pour des raisons d'optimisation d'encombrement, on recherche de plus en plus à faire des modules d'épaisseur la plus faible possible, typiquement inférieure à 4,5 mm. Cela permet notamment de pouvoir munir une plus grande variété de poignées d'ouvrant avec un unique module. Le problème posé par cette réduction d'épaisseur e réside dans le fait qu'il n'est plus possible d'obtenir une dissymétrie dans la localisation des électrodes de mesure 2 et 2'. En effet, comme visible sur la figure 2, plus l'épaisseur e est réduite, plus les électrodes de mesures 2 et 2' vont se retrouver à égale distance entre le face avant 10 et la face arrière 11, ou, à tout le moins, à une distance de la face arrière 11 qui ne sera pas suffisante pour éviter les fausses détections.

La présente invention a pour objet de proposer une solution au problème précédent.

Plus précisément, l'invention a pour objet un capteur de présence destiné à être intégré dans une poignée d'ouvrant, notamment pour véhicule automobile, tel que défini dans la revendication 1.

Ainsi, contrairement à un blindage classique qui aurait pour effet de réduire la sensibilité du capteur à la fois au niveau de la face arrière, mais malheureusement aussi au niveau de la face avant, les expériences menées par la Demanderesse ont montré qu'il était possible d'avoir une structure ajourée permettant un blindage efficace ayant pour effet de réduire significativement la sensibilité à l'arrière du capteur.

Dans un mode de réalisation préférentiel, la structure ajourée se présente sous la forme d'un treillis métallique.

L'invention sera mieux comprise au vu de la description suivante faite en référence aux figures annexées, dans lesquelles :
- les figures 1a et 1b illustrent schématiquement deux vues en plan d'un module comprenant un capteur de présence de type capacitif ;
- la figure 2 illustre schématiquement une vue en plan, similaire à la figure 1b, d'un second module d'épaisseur plus faible ;
- les figures 3a et 3b illustrent schématiquement un module selon un mode de réalisation préférentiel de l'invention ;
- les figures 4a et 4b montrent des simulations des lignes de champs électriques lors de l'approche d'une main respectivement par la face avant et par la face arrière du module de la figure 2;
- les figures 5a et 5b montrent des simulations des lignes de champs électriques lors de l'approche d'une main respectivement par la face avant et par la face arrière du module des figures 3a et 3b conformes à l'invention.

Les figures 1a, 1b et 2 ont déjà été décrites ci-dessus. Sur les figures 3a et 3b, les éléments communs avec ceux déjà décrits portent les mêmes références.

Conformément à l'invention, le nouveau module comporte, placé à l'arrière de la face arrière 11 du boîtier, un élément de blindage métallique 4 relié à la masse, et présentant une structure ajourée s'étendant en regard au moins des électrodes de mesure 2 et 2'. Le but de cette structure ajourée est de réduire au maximum la capacité parasite de cet élément de blindage de manière à n'avoir aucune ou peu d'influence sur les zones de détection S et S', tout en conservant sa fonction première de blindage pour en revanche diminuer la sensibilité du capteur au niveau de sa face arrière 11.

Conformément à la figure 3b, l'élément de blindage est de préférence réalisé sous la forme d'un treillis conducteur, en cuivre ou en zinc, dont les fils conducteurs sont par exemple espacés d'environ 2 mm.

D'autres structures ajourées peuvent cependant être envisagées, par exemple une plaque métallique présentant des ouvertures en nombre et taille suffisantes pour limiter au maximum le rapport entre la surface active du blindage et sa surface réelle.

L'élément de blindage 4 est fixé à l'arrière du module par tout moyen, par exemple par collage. En variante, l'élément de blindage peut être réalisé par des techniques de dépôts métallisés à l'arrière du module 1.

Dans l'exemple représenté sur les figures, l'élément de blindage est un seul et même treillis s'étendant en regard des deux électrodes de mesure 2 et 2', mais aussi des électrodes de référence 3 et 3'. Dans un autre mode de réalisation possible, on pourrait avoir deux éléments de blindage, l'important étant qu'ils s'étendent en regard au moins des électrodes de mesures 2 et 2', et qu'ils soient tout deux reliés à la masse.

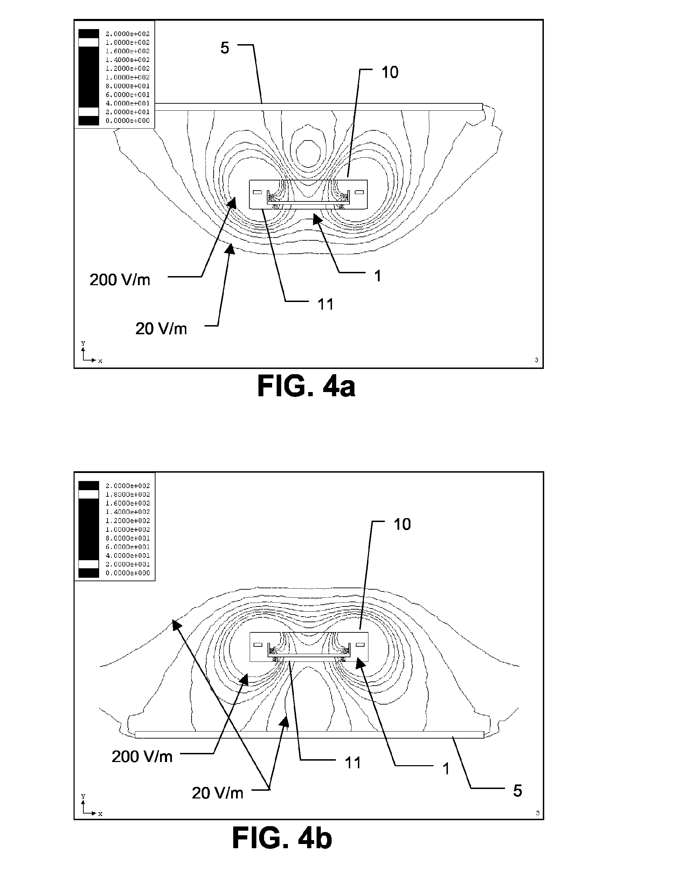

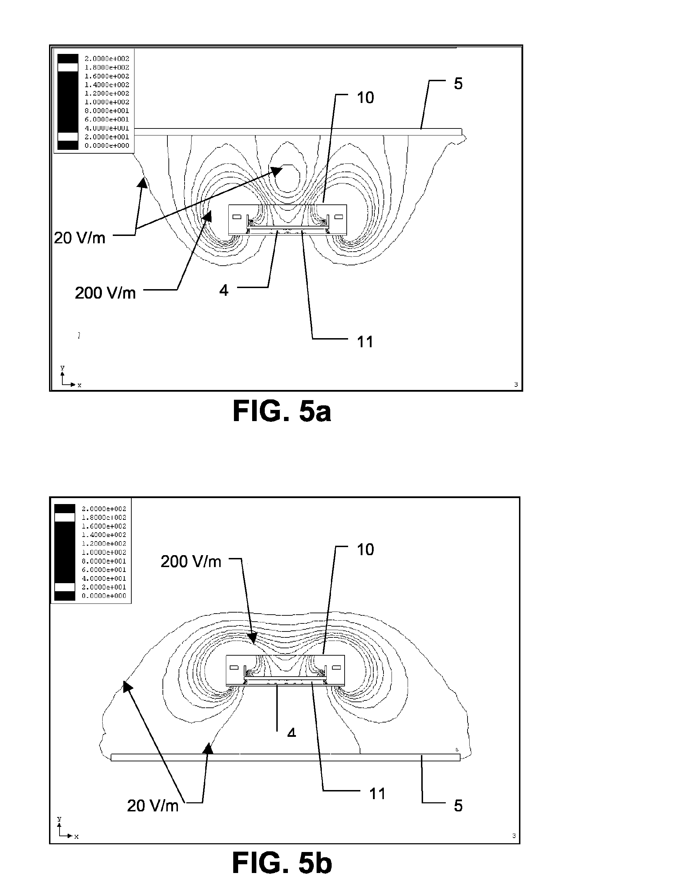

Les conséquences de l'ajout de l'élément de blindage 4 sont visibles sur les simulations présentées sur les figures 4a, 4b d'une part, et figures 5a, 5b d'autres part.

Plus précisément, les niveaux des lignes de champs électriques ont d'abord été simulés dans le cas d'un module sans élément de blindage, lors de l'approche d'une main par la face avant 10 du module 1 (figure 4a) puis par la face arrière 11 de ce même module. La main est matérialisée sur les différents figures par la référence 5, et se comporte comme une masse électrique.

Sur les différents figures, les niveaux des lignes de champs décroissent depuis une valeur maximum de 200 V/m à une valeur de 20 V/m par pas de 20 V/m. Sur la figure 4a, on distingue nettement les deux zones de détection à l'avant.

En outre, on constate sur la figure 4b de nombreuses lignes de champs de niveau supérieur ou égal à 20 V/m, interceptant le plan de la main 5. Cela traduit une sensibilité du capteur trop importante au niveau de la face arrière 11.

Sur les figures 5a et 5b simulant ces lignes de champs avec un module conforme à l'invention muni de son élément de blindage à structure ajourée, on constate que, pour une même distance de la main 5 au capteur, il y a moins de lignes de champs qui rejoignent le plan de la main 5 quand celle-ci s'approche par la face arrière (figure 5b). De plus, les lignes de champs qui atteignent le plan de la main ont un niveau au plus égal à 20 V/m. On a donc significativement réduit la sensibilité à l'arrière du module.

Cependant, si l'on compare les figures 4a et 5a, on constate que les niveaux et formes des lignes de champs entre le plan de la main 5 et la face avant 10 du module sont équivalentes. Ainsi, l'élément de blindage n'a pratiquement pas affecté la sensibilité du capteur sur sa face avant 10 dite active.

## Revendications

1. Capteur de présence destiné à être intégré dans une poignée d'ouvrant, notamment pour véhicule automobile, comportant
- un boîtier (1) en matériau non conducteur électriquement, de forme générale sensiblement parallélépipédique présentant une face avant (10) et une face arrière (11) sensiblement parallèles, le boîtier étant destiné à être monté dans une partie mobile de la poignée d'ouvrant de façon à ce que ladite face avant (10) s'étende parallèlement à la surface de l'ouvrant et à distance de la surface de l'ouvrant ;
- au moins une électrode de mesure (2) et une électrode de référence (3) reliée à une masse, placées à l'intérieur du boîtier et couplées entre elles de manière à générer des lignes de champs électriques s'étendant partiellement à l'extérieur du boîtier (1) de manière à créer une zone de détection ;
**caractérisé en ce que** ladite face avant (10) constituant la face active du capteur et ladite zone de détection étant créée au voisinage de la face avant (10) et de la face arrière (11), le capteur de présence comporte en outre un élément de blindage métallique (4) relié à la masse, placé à l'arrière de ladite face arrière et s'étendant en regard au moins de l'électrode de mesure (2),
et **en ce que** cet élément de blindage (4) présente une structure ajourée choisie de manière à réduire les lignes de champs électriques de la zone de détection au niveau de la face arrière (11), tout en présentant une capacité parasite faible pour avoir une influence négligeable sur les lignes de champs électriques de la zone de détection au niveau de la face avant (10).

2. Capteur de présence selon la revendication 1, **caractérisé en ce que** la structure ajourée est un treillis conducteur.

3. Capteur de présence selon l'une quelconque des revendications précédentes, **caractérisé en ce que** l'élément de blindage (4) est fixé sur l'arrière du boîtier (1) par collage.

4. Capteur de présence selon l'une quelconque des revendications 1 ou 2, **caractérisé en ce que** l'élément de blindage est réalisé sur la face arrière (11) par dépôt métallisé.
